(19)

Europäisches Patentamt

European Patent Office

Office européen des brevets

(11) **EP 3 282 468 A1**

## (12) EUROPEAN PATENT APPLICATION

(43) Date of publication:
**14.02.2018 Bulletin 2018/07**

(51) Int Cl.:
**H01J 37/28** *(2006.01)*  **G01N 23/00** *(2006.01)*

(21) Application number: **16183371.0**

(22) Date of filing: **09.08.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **Universität Wien**
**1010 Vienna (AT)**

(72) Inventors:
• **Kotakoski, Jani**
**1090 Wien (AT)**

• **Susi, Toma**
**1090 Wien (AT)**
• **Meyer, Jannik C.**
**1090 Wien (AT)**

(74) Representative: **Harrison, Robert John**
**24IP Law Group**
**Sonnenberg Fortmann**
**Patent- und Rechtsanwälte**
**Postfach 33 08 65**
**80068 München (DE)**

(54) **METHOD AND APPARATUS FOR DETERMINATION OF AN ISOTOPE CONCENTRATION USING A MICROSCOPE WITH ENERGETIC PARTICLES**

(57) A method of determining an isotope concentration in a sample (20), such as a graphene sample, is disclosed and the method comprises imaging (130) a section of the sample (20) with a microscope (10) using particle irradiation over a period of time, identifying (135) a change in the image contrast due to lost atom(s) in at least one of the series of images and calculating (140) an accumulated irradiation dose until identification of the change in contrast. The isotope concentration at the section of the sample (20) can be determined (160) from a comparison to a theoretical model or experimental results. The microscope (10) is a scanning transmission electron microscope in one aspect of the invention.

Fig. 1A

## Description

### Field of the Invention

The invention relates to a method and an apparatus for determination of an isotope concentration in a sample, such as a graphene sample, using a microscope, such as a transmission electron microscope or an ion microscope.

### Background of the Invention

Transmission electron microscopy (TEM) has become an interesting tool for not only atomic resolution imaging but also the manipulation of materials. In addition to TEM, other microscopy techniques have been developed to image samples using other particles, such as ions in the helium ion microscope.

TEM is a particularly powerful tool for studying low-dimensional materials such as graphene, in which each one of the atoms can be distinguished. Spectroscopy of single atoms, including their spin state, has together with Z-contrast imaging already allowed the identity and bonding of individual atoms to be determined. However, discerning the isotopes of a particular element in a sample has not to date been possible in a microscope.

### Summary of the Invention

This disclosure teaches a method and apparatus to differentiate between isotopes of the same element in a sample by quantifying the probability of ejecting atoms by the energetic particles, such as electrons or ions, used for imaging in a microscope. In a first step, the displacement probability in the sample is determined. This determination can either be theoretically described via scattering theory and a quantum mechanical model of lattice vibrations coupled with density functional theory simulations, or the displacement probability can be directly measured. After this displacement probability is established, the isotopes can be distinguished because of their differing mass.

This disclosure teaches a method of determining an isotope concentration in a sample comprising imaging a section of the sample with a transmission microscope over a period of time, storing a series of images of the section of the sample over the period of time and identifying at least one vacancy in at least one of the series of images. The accumulated energy dose until identification of the at least one vacancy is calculated and comparing with a stored model to determine the isotope concentration at the section of the sample from the comparison. Alternately, if the microscope does not allow atomicresolution imaging, detection of changing image contrast due to atom(s) lost from the sample can be used to determine the isotope concentration.

One example of the sample used in this disclosure is a graphene sample, which is grown from either of the two stable isotopes ($^{12}$C or $^{13}$C). The method is also applicable to other materials that are low-dimensional or atomically thin (substantially two-dimensional) in nature.

The imaging is performed using energetic particles, such as but not limited to one of electrons or ions, or by other energetic particles created by the collision of electrons or ions with the atoms in the sample. The stored model can be either a theoretical model, calculated as set out in this disclosure, or a practical one based on experimental measurements, as also demonstrated in this disclosure.

An apparatus for the determination of an isotope concentration is also taught. The apparatus comprises a microscope for imaging a section of a sample and irradiating the sample with energetic particles, such as electrons or ions, a detector for recording a series of images of the section of the sample and a memory store for storing a model. A processor is adapted to identify appearance of a vacancy or a change in image contrast corresponding to a lost atom or several atoms in at least one of the series of images, calculate an accumulated energy dose leading to the appearance of the vacancy and compare the accumulated energy dose with the stored model to determine the isotope concentration in the sample.

This disclosure describes the invention in terms of a scanning transmission electron microscope. The teachings are not limited to the use of such a microscope but are also more generally applicable to microscopes using energetic particles, such as transmission electron microscopes or ion microscopes. It will also be noted that the disclosure is described in terms of resolution of individual atoms, but could be also be used for investigating larger areas with lower resolution.

In a second step, the spatial resolution of the method by ejecting atoms from selected nanoscale areas of a graphene sample with mixed isotopes is shown. This ejection allows the estimation of the local isotope concentration with a precision better than twenty percent. An analyte mass of less than 200 zg was required for the analysis.

The method is demonstrated using graphene and STEM. The method is thought to be applicable to other low-dimensional materials and to any microscope that allows imaging with particles such as electrons or ions or simultaneous irradiation with energetic particles such as electron or ions.

**Description of the Figures**

Figs. 1A-1B show an outline of the experimental setup and method.

Fig. 2 shows creating and refilling of a vacancy in the sample.

Fig. 3 shows the displacement cross-section of $^{12}$C and $^{13}$C measured at different acceleration voltages.

Fig. 4 shows an example of the local isotope analysis.

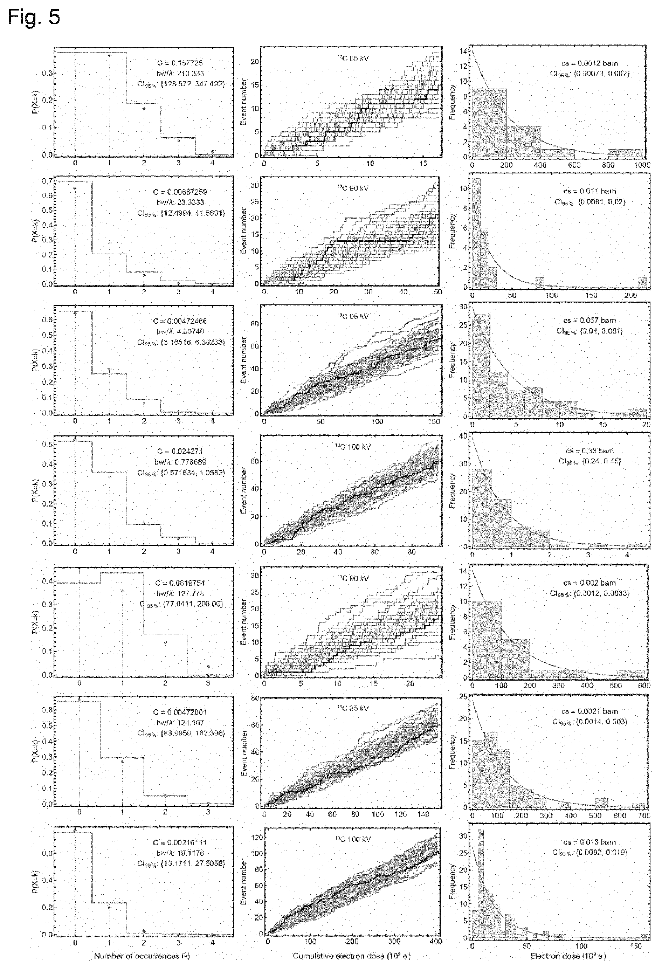

Fig. 5 shows statistical analyses of the dose data.

Fig. 6 shows an outline of the method.

**Detailed Description of the Invention**

The invention will now be described on the basis of the drawings. It will be understood that the embodiments and aspects of the invention described herein are only examples and do not limit the protective scope of the claims in any way. The invention is defined by the claims and their equivalents. It will be understood that features of one aspect or embodiment of the invention can be combined with a feature of a different aspect or aspects and/or embodiments of the invention.

It is shown here that the quantum mechanical description of lattice vibrations coupled with scattering theory enables an accurate modelling of stochastic ejection of single atoms from a graphene layer, which consists of either of the two stable carbon isotopes, similar to, for example, see Meyer [2012].

The method employed in this disclosure rests on a difference between energetic particles, such as electrons or ions, and photons when used as a microscopy probe: particles due to their finite mass can transfer significant amounts of momentum to atoms in the sample. When one of the energetic particles is scattered by an interaction with an atomic nucleus in the sample, a maximal amount of kinetic energy can be transferred when it backscatters. When this transferred kinetic energy is comparable to the so-called displacement threshold energy required to eject one of the atoms from the material in the sample, atomic vibrations become important in activating otherwise energetically prohibited processes due to the motion of the nucleus in the direction of the particle beam.

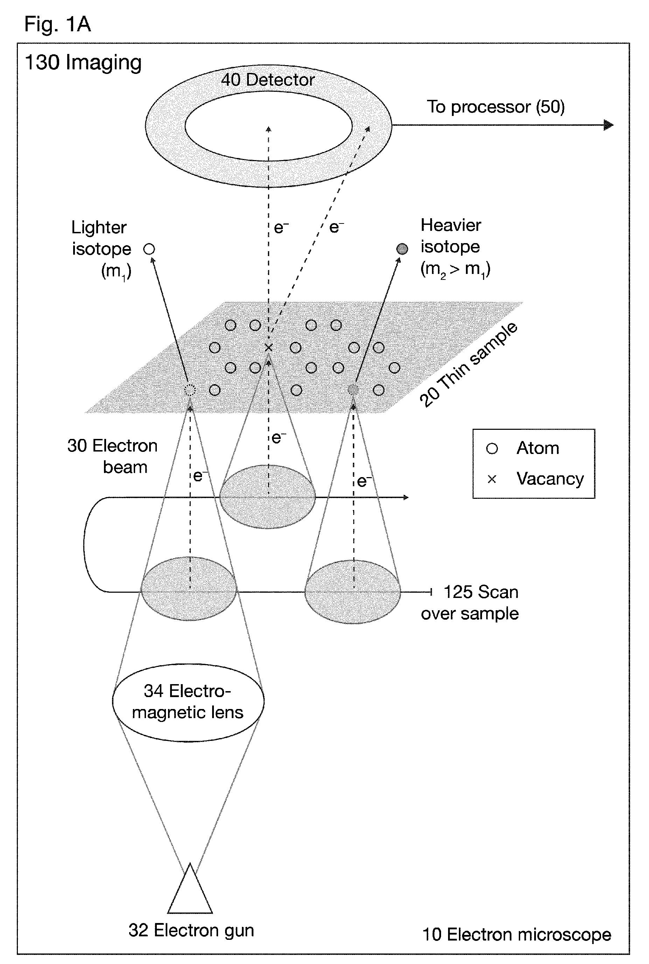

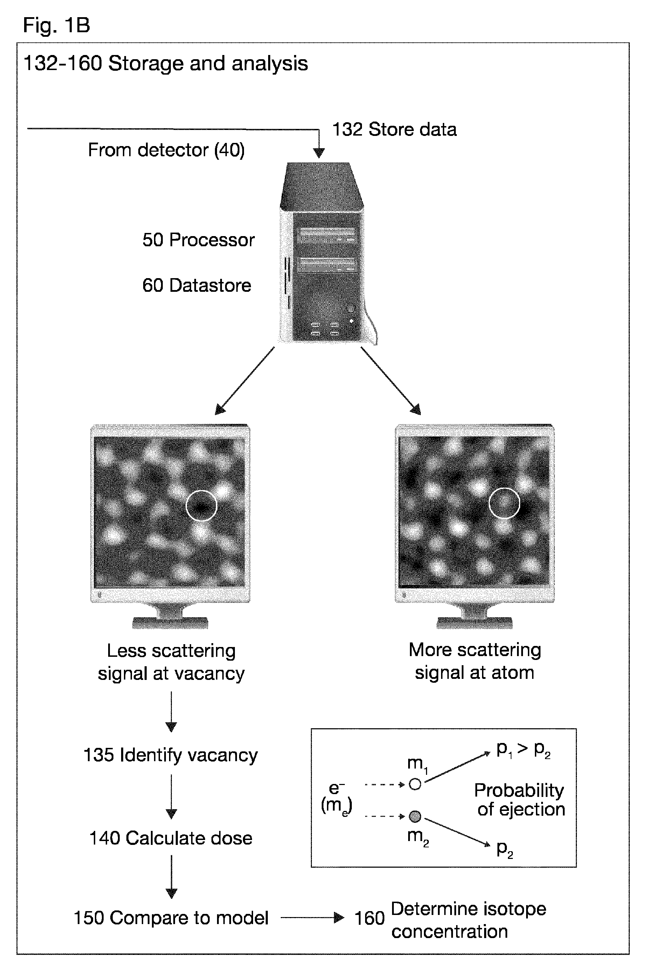

The experimental setup used is shown in outline in Figs. 1A and 1B in which a transmission electron microscope 10 images a sample 20 using an electron beam 30 generated by an electron gun 32 and focused on the sample 20 by an electromagnetic lens 34. A plurality of detectors 40 records the electrons scattered from the sample 20 and a processor 50 processes the data from the detectors 40. A datastore 60 is used to store the images and any calculations made by the processor 50. A Nion UltraSTEM100 was used as the scanning transmission electron microscope 10.

In one non-limiting example of this disclosure, graphene with two isotopes $^{12}$C ($m_1$) and $^{13}$C ($m_2$) was used, but this is not limiting of the invention and it is thought that other low-dimensional materials, such as, but not limited to borophene, phosphorene, silicene, germanene, stanene, hexagonal boron nitride (hBN), transition metal dichalcogenides of chemical form $MX_2$ (where M is a transition metal atom such as Mo or W, and X is a chalcogen atom, S, Se or Te), or two-dimensional oxides. The selection of materials could also potentially extend to van der Waals heterostructures of a few layers or other thin crystalline materials, provided a difference in the displacement probability of an atomic species can be uniquely determined.

In the examples discussed in this disclosure, commercial monolayer graphene samples (Quantifoil® R 2/4, Graphenea) were used, as well as samples of $^{13}$C graphene synthesized by chemical vapor deposition (CVD) on Cu foils using $^{13}$C-substituted $CH_4$ as carbon precursor, and subsequently transferred onto Quantifoil TEM grids. An additional sample consisted of grains of $^{12}$C and $^{13}$C graphene on the same grid, synthesized by switching the precursor during growth. The synthesis of this additional sample is given below.

It will be appreciated that the method outlined in this disclosure is not limited to STEM. For example, a parallel illumination TEM with atomic resolution would also work, although scanning has the advantage of not averaging the image contrast over the field of view. It is thought that also other microscopes, such as ion microscopes could be used similarly for this purpose.

A quantum description of vibrations in the sample 20 can be described as follows. The velocities of atoms in a solid material (or sample) are distributed based on a temperature-dependent velocity distribution, as defined by the vibrational modes of the solid material. Due to the geometry of a typical transmission electron microscopy (TEM) a study of a two-dimensional material, the so-called out-of-plane velocity $v_z$, whose distribution is characterized by the mean square velocity $v_z^2(T)$, is here of interest A good estimate for this out of plane velocity can be achieved by calculating the kinetic energy of the atoms via the thermodynamic internal energy, which is evaluated using the out-of-plane phonon density of states (DOS) $g_z(\omega)$, where $\omega$ is the phonon frequency.

As a starting point, the partition function $Z = \mathrm{Tr}\{e^{-H/(kT)}\}$ is calculated. Tr denotes the trace operation and $k$ is the Boltzmann constant and $T$ the absolute temperature. We evaluate this trace for the second-quantized Hamiltonian $H$ describing harmonic lattice vibrations:

$$Z = \sum_{n_{j_1}(\mathbf{k}_1)=0}^{\infty} \cdots \sum_{n_{j_{3r}}(\mathbf{k}_N)=0}^{\infty} \exp\left(-\frac{1}{kT}\sum_{\mathbf{k}j}\hbar\omega_j(\mathbf{k})\left[n_j(\mathbf{k})+\frac{1}{2}\right]\right) = \prod_{\mathbf{k}j}\frac{\exp\left(-\frac{1}{2}\hbar\omega_j(\mathbf{k})/(kT)\right)}{1-\exp\left(-\hbar\omega_j(\mathbf{k})/(kT)\right)}, \quad (1)$$

where h is the reduced Planck constant, $\mathbf{k}$ the phonon wave vector, $j$ the phonon branch index running to $3r$ ($r$ being the number of atoms in the unit cell), $\omega_j(\mathbf{k})$ the eigenvalue of the $j^{th}$ mode at $\mathbf{k}$, and $n_j(\mathbf{k})$ the number of phonons with frequency $\omega j(\mathbf{k})$.

After computing the internal energy $U = F - T\left(\frac{\partial F}{\partial T}\right)_V$ from the partition function via the Helmholtz free energy $F = -kT \ln Z$, we obtain the Planck distribution function describing the occupation of the phonon bands (discussed later). The internal energy $U$ must be separated into the in-plane $U_p$ and out-of-plane $U_z$ components, and take into account that half of the thermal energy equals the kinetic energy of the atoms. This gives the out-of-plane mean square velocity of a single atom in a simple two-atom unit cell as

$$\overline{v_z^2}(T) = U_z/(2M) = \frac{\hbar}{2M}\int_0^{\omega_z} g_z(\omega)\left[\frac{1}{2} + \frac{1}{\exp(\hbar\omega/(kT))-1}\right]\omega\,\mathrm{d}\omega, \quad (2)$$

where $M$ is the mass of the vibrating atom, $\omega_z$ is the highest out-of-plane mode frequency, and the correct normalization of the number of modes $\left(\int_0^{\omega_z}g_z(\omega)\,\mathrm{d}\omega = 2\right)$ is included in the DOS.

To estimate the phonon density of states, we calculated through density functional theory (DFT; GPAW package, see Enkovaara [2010]) the graphene phonon band structure via the dynamical matrix using the 'frozen phonon method'.

Taking the density of the components corresponding to the out-of-plane acoustic (ZA) and optical (ZO) phonon modes and solving Eq. $\underline{2}$ numerically, we obtain a mean square velocity $v_z^2 \approx 3.17 \times 10^5$ m²/s² for a $^{12}$C atom in normal graphene. This description can be extended to 'heavy graphene' (consisting of $^{13}$C instead of a natural isotope mixture). A heavier atomic mass affects the velocity through two effects: the phonon band structure is scaled by the square root of the mass ratio (from the mass prefactor of the dynamical matrix), and the squared velocity is scaled by the mass ratio itself (Eq. $\underline{2}$). At room temperature, the first correction reduces the velocity by 3% in fully $^{13}$C graphene compared to normal graphene, and the second one reduces the velocity by an additional 10%, resulting in $v_{z^2,13} \approx 2.86 \times 10^5$ m²/s².

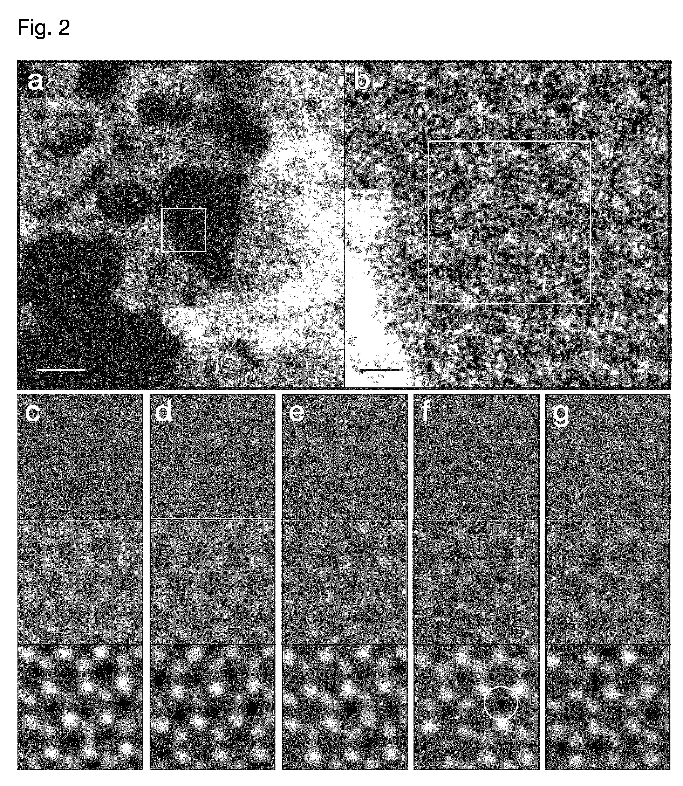

The experiments consisted of recording time series at room temperature using the electron transmission microscope 10, in which the field of view and frame time were chosen so that in the sample 20 each atom, or its loss, was visible in every frame. An example is shown in Fig. 2.

Fig. 2 shows the creation and refilling of a vacancy. The detector images are medium angle annular dark field (MAADF) detector images recorded at 95 kV. Panel a shows a spot on the graphene membrane of the sample 20, containing clean monolayer graphene areas (dark) and overlying contamination (bright). Panel b shows a closer view of the area marked by the rectangle in panel a, with the irradiated area of the following panels being denoted by the rectangle. Panels c-g show five consecutive STEM frames ($\sim 1 \times 1$ nm², $512 \times 512$ px, 2.2 s per frame) recorded at the clean monolayer area of the graphene sample 20. A single carbon atom has been ejected in the fourth frame (shown in panel f, circle), but the vacancy is filled already in the next frame (panel g). The top row of (c-g) contains the unprocessed images. The middle row has been treated by a Gaussian blur with a radius of 2 pixels (px), and the bottom row has been filtered with a double Gaussian procedure ($\sigma_1 = 5$ px, $\sigma_2 = 2$ px, weight = 0.16).

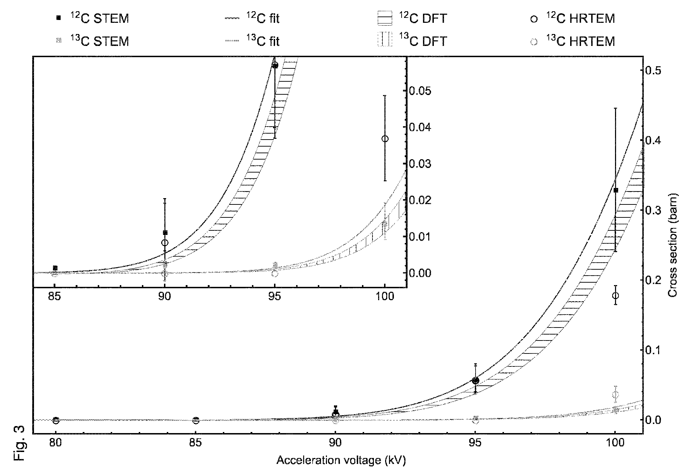

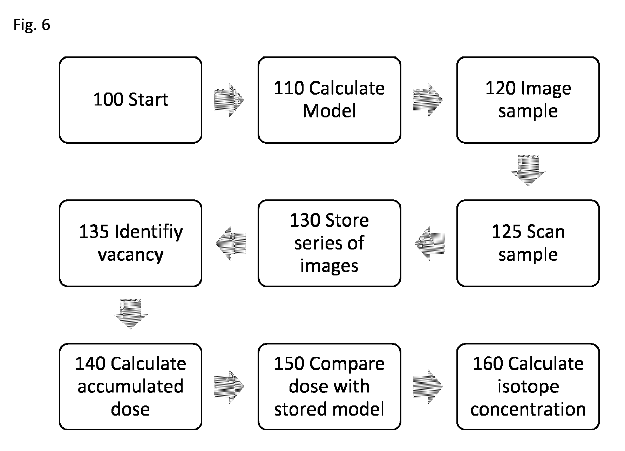

From the experimental datasets within which a clear displacement, i.e. creating the vacancy was observed, we calculated the accumulated electron dose until the frame where the vacancy appeared. The distribution of doses corresponds to a Poisson process whose expected value was found by log-likelihood minimization (as shown in Fig. 6), directly yielding the probability of creating the vacancy. Fig. 3_displays the corresponding displacement cross sections measured at voltages between 80 and 100 kV for normal (1.109% $^{13}$C) and heavy graphene (~99% $^{13}$C), alongside

values measured earlier (Meyer [2012]) using high-resolution TEM (HRTEM). For low-probability processes, the cross section is highly sensitive to both the atomic velocities and the displacement threshold energy. Since heavier atoms do not vibrate with as great a velocity, the heavier atoms receive less of a boost to the momentum transfer from an impinging electron from the electron microscope. Thus, fewer ejections are observed for the $^{13}$C isotope in the graphene sample 20.

The theoretical cross section $\sigma_d(T,E_e)$ curves in Fig. 3_were calculated for each voltage. The motion of the nuclei was included via a Gaussian distribution of atomic out-of-plane velocities $P(v_z,T)$ characterized by the DFT-calculated $v_z^2$, similar to the approach of Meyer [2012]. A common displacement threshold energy was fitted to the dataset by minimizing the variance-weighted mean square error (the 100 kV HRTEM point was omitted from the fitting, since it was underestimated due to the undetected refilling of vacancies). The optimal $T_d$ value was found to be 21.14 eV, resulting in a good description of all the measured cross sections. The C09 van der Waals exchange correlation functional (Cooper [2010]) gives $T_d$ [21.25, 21.375], very close to the experiment. We see from the good fit to the normal and heavy graphene datasets that the theory accurately describes the contribution of vibrations. Further, the HRTEM data and the STEM data are equally well described by the theory despite having several orders of magnitude different irradiation dose rates.

The STEM data in Fig. 3 is marked with squares, and earlier HRTEM data (Meyer [2012]) with circles. The error bars correspond to the 95% confidence intervals of the Poisson means (STEM data) or to previously reported estimates of statistical variation (HRTEM data). The solid curves are derived from the theoretical model with an error-weighted least-squares best-fit displacement threshold energy of 21.14 eV. The shaded areas correspond to our theoretical model using the DFT threshold range. The inset is a closer view of the low cross section region.

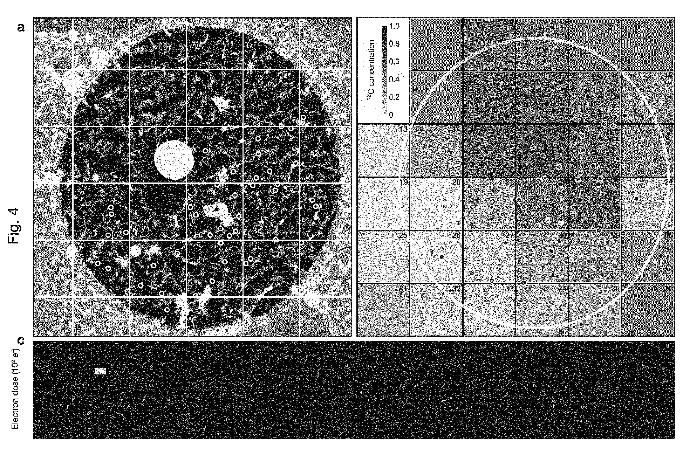

A sample 20 comprising joined grains of $^{12}$C and $^{13}$C graphene was used to test the spatial resolution of the method and the results are shown in Fig. 4. Isotope labeling combined with Raman spectroscopy mapping is a powerful tool for studying chemical vapor deposition growth of graphene, which is of considerable interest. However, the spatial resolution of Raman spectroscopy is limited, making it impossible to obtain atomic-scale information of the transition region between grains of different isotopes of the carbon. Atomic probe tomography can reach sub-nm spatial resolution, but it requires laborious sample preparation and dedicated instrumentation. By contrast, here the data are acquired via STEM imaging.

Panel a) of Fig. 4 shows a STEM micrograph of a hole in the carbon support film (1.3 $\mu$m in diameter), covered by a monolayer of graphene. In each of the overlaid spots, 4-15 fields of view were irradiated. The dimensions of the overlaid grid correspond to the pixels of a Raman map recorded over this area. Panel b) of Fig. 4 is an isotope concentration map where the colors of the grid squares denote $^{12}$C concentration based on the fitting of the Raman 2D band response. The overlaid spots correspond to the panel a, with grey scale denoting the concentration of $^{12}$C estimated from the mean of the measured doses. Panel c illustrates locally measured mean doses and their standard errors plotted on a log scale. The horizontal colored areas show the means $\pm$ standard errors of doses simulated for the theoretical $^{12}$C and $^{13}$C cross sections. Note that the greater variation in the experimental doses is expected for areas containing a mix of both carbon isotopes.

The local isotope analysis is based on fitting the mean of the locally measured electron doses with a linear combination of doses generated by Poisson processes corresponding to $^{12}$C and $^{13}$C graphene using the theoretical cross section values at 100 kV. Although each dose results from a stochastic process, the expected doses for $^{12}$C and $^{13}$C are sufficiently different that measuring several displacements decreases the error of their mean well below the expected separation (see Fig. 4c). To estimate the expected statistical variation for a certain number of measured doses, we generated a large number of sets of n Poisson doses, and calculated their means and standard errors as a function of the number of doses in each set. The calculated relative errors scale as $1/n$ and correspond to the precision of our measurement, which is better than 20% for as few as five doses in the ideal case.

Working at 100 kV, we selected spots (43 in total) containing areas of clean graphene in the sample 20 only a few tens of nanometers in size (as known from panel a in Fig. 2), irradiating 4-15 fields of view (mean 7.8) $1\times1$ nm$^2$ in size until the first displacement occurred (See panel 4 of Fig. 2). Comparing the mean of the measured doses to the generated data, we can estimate the isotope concentration responsible for such a dose. This assignment was corroborated by Raman mapping over the same area, allowing the two isotopes to be distinguished by their differing Raman shift. A general trend from $^{12}$C-rich to $^{13}$C-rich regions is captured by both methods (as shown in Fig. 4b), but a significant local variation in the measured doses is detectable (Fig. 4c).

In isotope ratio mass spectrometry precisions of 0.01 % and accuracies of 1% have been reported. However, these measurements are not spatially resolved. For spatially resolved techniques, one of the most widely used is time-of-flight secondary ion mass spectroscopy (ToF-SIMS). It has a lateral resolution typically of several micrometers, which can be reduced to around 100 nm by finely focusing the ion beam. In the case of ToF-SIMS, separation of the $^{13}$C signal from $^{12}$C$^1$H is problematic, resulting in a reported precision of 20% and an accuracy of ~11% (see Stephan [2001]). The state-of-the-art performance in local mass analysis can be achieved with atom-probe tomography (APT), which can record images with sub-nanometer spatial resolution in all three dimensions. A recent APT study of the $^{13}$C/$^{12}$C ratio in detonation nanodiamonds reported a precision of 5%, but biases in the detection of differently charged ions limited accuracy to ~25% compared to the natural isotope abundances (see Lewis [2015]).

A limitation of ToF-SIMS is its inability to discriminate between the analyte and contaminants and that it requires uniform isotope concentrations over the beam area for accurate results. APT requires the preparation of specialized needle-like sample geometries, and a laborious reconstruction process to analyse its results. A further limitation of APT is that it is currently has a detection efficiency of only 60%.

In the method set out in this document, we are only able to resolve relative mass differences between isotopes of the same element in the same chemical environment. While we do not need to resolve mass differences between different elements, since these differ in their image contrast, we do need to detect the ejection of single atoms, which limits the method to atomically thin materials (i.e. low dimensional materials). The method captures the isotope information concurrently with atomic resolution imaging in a general-purpose electron microscope without the need for additional detectors.

The areas sampled were in total less than 340 $nm^2$ in size, containing approximately 6600 carbon atoms of which 337 were ejected. Thus while the nominal mass required for the complete analysis was already extremely small (131 zg), the displacement of only five atoms is required to distinguish a concentration difference of less than twenty percent.

A summary of the method is shown in Fig. 6. The method starts at step 100 and in step 110 a model was calculated to reflect the displacement threshold energies of the isotopes in the sample 20. In step 120 a series of images was created by scanning the electron beam 30 over the sample 20 in step 125 and imaging sections of the sample 20 with the electron microscope 10. The series of images were recorded in the datastore 60 in step 130 and analysed in step 135 to find any vacancies in the series of images. The processor 50 can calculate the accumulated electron dose until one or more of the atoms in the sample 20 is displaced, leaving the vacancy in step 140. The accumulated electron dose is compared in step 150 with the stored model and in step 160 the isotope concentration at the imaged area of the sample 20 is determined.

The method and apparatus of this disclosure has numerous applications in scientific research and investigation of materials. It can be used, for example, to investigate chemical reactions and physical processes by labelling substances with different isotopes and then investigating the distribution of the isotopes.

It will be appreciated that the method and apparatus have been illustrated for the case in which the microscope can resolve images to the atomic scale. It would also be possible to use a similar method at a large scale by looking at the levels of contrast between different ones of the images in step 135.

*Methods and Examples*

Quantum model of vibrations

The out-of-plane mean square velocity $v_z^2(T)$ can be estimated by calculating the kinetic energy via the thermodynamic internal energy using the out-of-plane phonon density of states $g_z(\omega)$, where $\omega$ is the phonon frequency. In the second quantization formalism, the Hamiltonian for harmonic lattice vibrations is:

$$H = \sum_{\mathbf{k}}^{N} \sum_{j=1}^{3r} \hbar\omega_j(\mathbf{k})[b_{\mathbf{k}j}^{\dagger} b_{\mathbf{k}j} + \frac{1}{2}], \tag{3}$$

where $\mathbf{k}$ is the phonon wave vector, $j$ is the phonon branch index running to $3r$ ($r$ being the number of atoms in the unit cell), $\omega_j(\mathbf{k})$ the eigenvalue of the $j^{th}$ mode at $\mathbf{k}$, and $b_{\mathbf{k}j}^{\dagger}$ and $b_{\mathbf{k}j}$ are the phonon creation and annihilation operators, respectively.

Using the partition function $Z = \text{Tr}\{e^{-H/(kT)}\}$, where Tr denotes the trace operation and $k$ is the Boltzmann constant and $T$ the absolute temperature, and evaluating the trace using this Hamiltonian, we have

$$Z = \sum_{n_{j_1}(\mathbf{k}_1)=0}^{\infty} ... \sum_{n_{j_{3r}}(\mathbf{k}_N)=0}^{\infty} \exp\left(-\frac{1}{kT}\sum_{\mathbf{k}j}\hbar\omega_j(\mathbf{k})\left[n_j(\mathbf{k}) + \frac{1}{2}\right]\right) = \prod_{\mathbf{k}j} \frac{\exp\left(-\frac{1}{2}\hbar\omega_j(\mathbf{k})/(kT)\right)}{1 - \exp\left(-\hbar\omega_j(\mathbf{k})/(kT)\right)}, \tag{4}$$

where $n_j^{(k)} = b_{\mathbf{k}j}^{\dagger} b_{\mathbf{k}j}$ is the number of phonons with frequency $\omega_j(\mathbf{k})$.

The Helmholtz free energy is thus

$$F = -kT \ln Z = kT \sum_{\mathbf{k}j} \ln\left[2\sinh(\hbar\omega_j(\mathbf{k})/(2kT))\right]$$

$$(5)$$

and the internal energy of a single unit cell therefore becomes

$$U = F - T\left(\frac{\partial F}{\partial T}\right)_V = \sum_{\mathbf{k}j} \frac{1}{2}\hbar\omega_j(\mathbf{k})\coth(\hbar\omega_j(\mathbf{k})/(2kT)) = 3r\int \frac{1}{2}\coth(\hbar\omega/(2kT))g(\omega)\hbar\omega\,d\omega,$$

$$(6)$$

where in the last step the sum is expressed as an average over the phonon density of states. Using the identity ½ coth($x$/2) = ½ + 1/(exp($x$) - 1) yields the Planck distribution function describing the occupation of the phonon bands, and explicitly dividing the energy into the in-plane $U_p$ and out-of-plane $U_z$ components, we can rewrite this as

$$U = U_p + U_z = \int_0^{\omega_D} (g_p(\omega) + g_z(\omega))\left[\frac{1}{2} + \frac{1}{\exp(\hbar\omega/(kT)) - 1}\right]\hbar\omega\,d\omega,$$

$$(7)$$

where the number of modes is included in the normalization of the DOSes, i.e., $\int_0^{\omega_z} g_z(\omega)\,d\omega = 2$, corresponding to the out-of-plane acoustic (ZA) and optical (ZO) modes, and $\omega_D$ is the highest frequency of the highest phonon mode.

Since half of the thermal energy equals the average kinetic energy of the atoms, and the graphene unit cell has two atoms, the kinetic energy of a single atom is

$$E_{kin,z} = \frac{1}{2}M\overline{v_z^2} = \frac{1}{2}\frac{1}{2}U_z.$$

$$(8)$$

Thus, the out-of-plane mean square velocity of an atom becomes

$$\overline{v_z^2}(T) = U_z/(2M) = \frac{\hbar}{2M}\int_0^{\omega_z} g_z(\omega)\left[\frac{1}{2} + \frac{1}{\exp(\hbar\omega/(kT)) - 1}\right]\omega\,d\omega,$$

$$(9)$$

where $\omega_z$ is now the highest out-of-plane mode frequency. This can be solved numerically for a known $g_z(\omega)$.

Frozen phonon calculation

To estimate the phonon density of states, we calculated the graphene phonon band structure via the dynamical matrix, which was computed by displacing each of the two primitive cell atoms by a small displacement (0.06 Å) and calculating the forces on all other atoms in a 7×7 supercell ('frozen phonon method') using density functional theory as implemented in the GPAW package (Enkovaara [2010]). Exchange and correlation were described by the local density approximation (LDA), and a Γ-centered Monkhorst-Pack k-point mesh of 42×42×1 was used to sample the Brillouin zone. A fine computational grid spacing of 0.14 Å was used alongside strict convergence criteria for the structural relaxation (forces < $10^{-5}$ eV/Å per atom) and the self-consistency cycle (change in eigenstates < $10^{-13}$ eV$^2$ per electron).

Graphene synthesis and transfer

In addition to commercial monolayer graphene (Graphenea QUANTIFOIL ® R 2/4), the graphene samples were synthesized by chemical vapor deposition (CVD) in a furnace equipped with two separate gas inlets that allow for independent control over the two isotope precursors (i.e. either ~99% $^{12}CH_4$ or ~99% $^{13}CH_4$ methane). The as-received 25 $\mu$m thick 99.999% pure Cu foil was annealed for ~1 hour at 960 °C in a 1:20 hydrogen/argon mixture with a pressure of ~10 mbar. The growth of graphene was achieved by flowing 50 cm³/min of $CH_4$ over the annealed substrate while keeping the Ar/$H_2$ flow, temperature and pressure constant. For the isotopically mixed sample with separated domains, the annealing and growth temperature was increased to 1045 °C and the flow rate decreased to 2 cm³/min. After introducing $^{12}CH_4$ for 2 mins the carbon precursor flow was stopped for 10 s, and the other isotope precursor subsequently introduced into the chamber for another 2 min. This procedure was repeated with a flow time of one minute. After the growth, the $CH_4$ flow was interrupted and the heating turned off, while the Ar/$H_2$ flow was kept unchanged until the substrate reached room temperature. The graphene was subsequently transferred onto a holey amorphous carbon film supported by a TEM grid using a direct transfer method without using polymer.

Scanning transmission electron microscopy

Electron microscopy experiments were conducted using a Nion UltraSTEM100 scanning transmission electron microscope, operated between 80 and 100 kV in nearultrahigh vacuum (2 × 10⁻⁷ Pa). The instrument was aligned for each voltage so that atomic resolution was achieved in all of the experiments. The beam current during the experiments varied between 8 and 80 pA depending on the voltage, corresponding to dose rates of approximately 5-50 × 10⁷ e⁻/(Å²s). The beam convergence semiangle was 30 mrad and the semi-angular range of the medium-angle annular-dark-field (MAADF) detector was 60-200 mrad.

Poisson analysis

Assuming the displacement data are stochastic, the waiting times (or, equivalently, the doses) should arise from a Poisson process with mean $\lambda$. Thus the probability to find k events in a given time interval follows the Poisson distribution

$$f(k;\lambda) = \Pr(X = k) = \frac{\lambda^k e^{-\lambda}}{k!}. \tag{10}$$

To estimate the Poisson expectation value for each sample and voltage, the cumulative doses of each dataset were divided into bins of width w, and the number of bins with 0, 1, 2... occurrences were counted.

An error estimate for the mean was calculated using the approximate confidence interval proposed for Poisson processes with small means and small sample sizes

$$\text{CI}_{95\%} = \bar{\lambda} + \frac{Z_{2.5}^2}{2n} \pm Z_{2.5}\sqrt{\frac{\bar{\lambda}}{n}}, \tag{12}$$

where $\lambda$ is the estimated mean and $Z_{2.5}$ is the normal distribution single tail cumulative probability corresponding to a confidence level of (100 - $\alpha$) = 95%, equal to 1.96.

The statistical analyses were conducted using the Wolfram Mathematica software (version 10.5). Outputs of the Poisson analyses for the main datasets of normal and heavy graphene as a function of voltage are shown as Fig. 6.

Displacement cross section

The energy transferred to an atomic nucleus from a fast electron as a function of the electron scattering angle $\theta$:

$$E(\theta) \approx E_{max} \sin^2\left(\frac{\theta}{2}\right), \tag{13}$$

which is valid also for a moving target nucleus for electron energies > 10 keV as noted by Meyer and co-workers (Meyer [2012]). For purely elastic collisions (where the total kinetic energy is conserved), the maximum transferred energy $E_{max}$ corresponds to electron backscattering, i.e. $\theta = \pi$. However, when the impacted atom is moving, $E_{max}$ will also depend on its speed. 1. 183

To calculate the cross section, we use the approximation of McKinley and Feshbach (McKinley [1948]) of the original series solution of Mott to the Dirac equation, which is very accurate for low-Z elements and sub-MeV beams. This gives the cross section as a function of the electron scattering angle as

$$\sigma(\theta) = \sigma_R \left[ 1 - \beta^2 \sin^2(\theta/2) + \pi \frac{Ze^2}{\hbar c} \beta \sin(\theta/2)(1 - \sin(\theta/2)) \right],$$

$$(14)$$

where $\beta = v/c$ is the ratio of electron speed to the speed of light (0.446225 for 60 keV electrons) and $\sigma_R$ is the classical Rutherford scattering cross section

$$\sigma_R = \left( \frac{Ze^2}{4\pi\epsilon_0 2m_0 c^2} \right)^2 \frac{1 - \beta^2}{\beta^4} \csc^4(\theta/2).$$

$$(15)$$

Using Eq. 14 this can be rewritten as a function of the transferred energy as

$$\sigma(E) = \left( \frac{Ze^2}{4\pi\epsilon_0 2m_0 c^2} \frac{E_{max}}{E} \right)^2 \frac{1 - \beta^2}{\beta^4} \left[ 1 - \beta^2 \frac{E}{E_{max}} + \pi \frac{Ze^2}{\hbar c} \beta \left( \sqrt{\frac{E}{E_{max}}} - \frac{E}{E_{max}} \right) \right].$$

$$(16)$$

Distribution of atomic vibrations

The maximum energy (in eV) that an electron with mass $m_e$ and energy $E_e = eU$ (corresponding to acceleration voltage $U$) can transfer to a nucleus of mass M that is moving with velocity $v$ is

$$E_{max}(v, E_e) = \frac{(r + t)^2}{2M} = \frac{\left( \sqrt{E_e(E_e + 2m_e c^2)} + Mvc + \sqrt{(E_e + E_n)(E + 2m_e c^2 + E_n)} \right)^2}{2Mc^2},$$

$$(17)$$

where $r = \frac{1}{c}\sqrt{E_e(E_e + 2m_e c^2)} + Mv$ and $t = \frac{1}{c}\sqrt{(E_e + E_n)(E_e + 2m_e c^2 + E_n)}$ are the relativistic energies of the electron and the nucleus, and $E_n = Mv^2/2$ the initial kinetic energy of the nucleus in the direction of the electron beam.

The probability distribution of velocities of the target atoms in the direction parallel to the electron beam follows the normal distribution with a standard deviation equal to the temperature-dependent mean square velocity $v_z^2(T)$,

$$P(v_z, T) = \frac{1}{\sqrt{2\pi \overline{v_z^2(T)}}} \exp\left( \frac{-v_z^2}{2\overline{v_z^2(T)}} \right).$$

$$(18)$$

Total cross section with vibrations

The cross section is calculated by numerically integrating Eq. 16 multiplied by the Gaussian velocity distribution (Eq. 18) over all velocities $v$ where the maximum transferred energy (Eq. 17) exceeds the displacement threshold energy $T_d$:

$$\sigma(T, E_e) = \int_{E_{max}(v,E_e) \geq T_d} P(v,T)\sigma(E_{max}(v,E_e))\,dv \tag{19}$$

$$= \int_0^{v_{max}} \frac{1}{\sqrt{2\pi \overline{v_z^2}(T)}} \exp\left(\frac{-v^2}{2\overline{v_z^2}(T)}\right) \left(\frac{Ze^2}{4\pi\epsilon_0 2m_0 c^2}\frac{E_{max}(v,E_e)}{E}\right)^2 \frac{1-\beta^2}{\beta^4}$$

$$\left[1 - \beta^2 \frac{E}{E_{max}(v,E_e)} + \pi\frac{Ze^2}{\hbar c}\beta\left(\sqrt{\frac{E}{E_{max}(v,E_e)}} - \frac{E}{E_{max}(v,E_e)}\right)\right] \tag{20}$$

$$\Theta[E_{max}(v,E_e) - E_d]\,dv,$$

where $E_{max}(v,E_e)$ is given by Eq. 17, the term $\Theta[E_{max}(v,E_e) - E_d]$ is the Heaviside step function, $T$ is the temperature and $E_e$ is the electron kinetic energy. The upper limit for the numerical integration $v_{max} = 8\sqrt{\overline{v_z^2}}$ was chosen so that the velocity distribution is fully sampled.

Displacement threshold simulation

For estimating the displacement threshold energy, we used density functional theory molecular dynamics (DFT/MD. The threshold was obtained by increasing the initial kinetic energy of a target atom until it escaped the structure during the MD run. The calculations were performed using the grid-based projector-augmented wave code (GPAW), with the computational grid spacing set to 0.18 Å. The molecular dynamics calculations employed a double zeta linear combination of atomic orbitals (LCAO) basis for a 8×6 unit cell of 96 atoms, with a 5×5×1 Monkhorst-Pack k-point grid used to sample the Brillouin zone. A timestep of 0.1 fs was used for the Velocity-Verlet dynamics, and the velocities of the atoms initialised by a Maxwell-Boltzmann distribution at 50 K, equilibrated for 20 timesteps before the simulated impact. The exchange and correlation van der Waals functional C09 (Cooper [2010]) resulted in a calculated threshold energy of [21.25, 21.375] eV, in a good agreement with the experimental fit.

Varying mean square velocity with concentration

Since the phonon dispersion of isotopically mixed graphene gives a slightly different out-of-plane mean square velocity for the atomic vibrations, for calculating the cross section for each concentration, we assumed the velocity of mixed concentrations to be linearly proportional to the concentration

$$v_{mix} = cv_{12} + (1-c)v_{13}, \tag{21}$$

where c is the concentration of $^{12}$C and $v_{12/13}$ are the atomic velocities for normal and heavy graphene, respectively.

Raman spectroscopy

A Raman spectrometer (NT MDT Ntegra Spectra) equipped with a 532 nm excitation laser was used for Raman measurements. A computer-controlled stage allowed recording a Raman spectrum map over the precise hole on which the electron microscopy measurements were conducted, which was clearly identifiable from neighboring spot contamination and broken film holes.

The frequencies $\omega$ of the optical phonon modes vary with the atomic mass $M$ as $\omega$ $M^{-1/2}$ due to the mass prefactor of the dynamical matrix. This makes the Raman shifts of $^{13}$C graphene $(12/13)^{-1/2}$ times smaller, allowing the mapping and localization of $^{12}$C and $^{13}$C domains with a spatial resolution limited by the size of the laser spot (nominally -400 nm). The shifts of the G and 2D bands compared to a corresponding normal graphene sample are given by

$$\omega_{12}\left[1 - \sqrt{\frac{12 + c_0^{13}}{12 + (1-c)}}\right], \tag{22}$$

where $\omega_{12}$ is the G (2D) line frequency of the normal sample, $c_0{}^{13} = 0.01109$ is the natural abundance of $^{13}$C, and c is the unknown concentration of $^{12}$C in the measured spot.

Due to background signal arising from the carbon support film of the TEM grid, we analyzed the shift of the 2D band, where two peaks were in most locations present in the spectrum. However, in many spectra these did not correspond to either fully $^{12}$C or $^{13}$C graphene, indicating isotope mixing within the Raman coherence length. To assign a single value to the $^{12}$C concentration for the overlay of Figure 4, we took into account both the shifts of the peaks (to estimate the nominal concentration for each signal) and their areas (to estimate their relative abundances) as follows:

$$c_{12}^{total} = c_{12}^A \frac{A}{A+B} + c_{12}^B \frac{B}{A+B} = \left(1 - \frac{\omega_A - \omega_{12}}{\omega_{12} - \omega_{13}}\right) \frac{A}{A+B} + \frac{\omega_B - \omega_{13}}{\omega_{12} - \omega_{13}} \frac{B}{A+B}, \tag{23}$$

where $c_{12}{}^{A/B}$ are the nominal concentrations of $^{12}$C determined from the measured higher and lower 2D Raman shift peak positions, $\omega_{A/B}$ are the measured peak centers of the higher and lower 2D signals, and A and B are their integrated intensities. The peak positions of fully $^{12}$C and $^{13}$C graphene were taken from the highest and lowest peak positions in the entire mapped area (covering several dozen Quantifoil holes), giving $\omega_{12}$ = 2690 1/cm and $\omega_{13}$ = 2600 1/cm.

**References**

Cooper 2010: Cooper, V. R. Van der Waals density functional: An appropriate exchange functional. Physical Review B 81, 161104 (2010).

Enkovaara 2010: Enkovaara, J. et al. Electronic structure calculations with GPAW: a real-space implementation of the projector augmented-wave method. Journal of Physics: Condensed Matter 22, 253202 (2010).

Lewis 2015: Lewis, J. B., Isheim, D., Floss, C. & Seidman, D. N. 12C/13C-ratio determination in nanodiamonds by atom-probe tomography. Ultramicroscopy 159, 248 - 254 (2015).

McKinley 1948: McKinley, W. A., Jr. & Feshbach, H. The Coulomb scattering of relativistic electrons by nuclei. Physical Review 74, 1759-1763 (1948).

Meyer 2012: Meyer, J. C. et al. Accurate measurement of electron beam induced displacement cross sections for single-layer graphene. Physical Review Letters 108, 196102 (2012).

Stephan 2001: Stephan, T. TOF-SIMS in cosmochemistry. Planetary and Space Science 49, 859 - 906 (2001).

**Claims**

1. A method of determining an isotope concentration in a sample (20) comprising:

   - imaging (130) a section of the sample (20) with a microscope (10) using energetic particles over a period of time;
   - storing (132) a series of images of the section of the sample (20) over the period of time;
   - identifying (135) differing contrast in at least one of the series of images;
   - calculating (140) an accumulated irradiation dose until identification of at least one image with the differing contrast;
   - comparing (150) the accumulated irradiation dose with a stored model; and
   - determining (160) the isotope concentration at the section of the sample (20) from the comparison.

2. The method of claim 1, wherein the sample (20) is a low-dimensional sample.

3. The method of claim 1 or 2, wherein the energetic particles are one of electrons, ions, or neutral atoms or molecules.

4. The method of any of the above claims, wherein the microscope is a scanning transmission electron microscope.

5. The method of any of the above claims, wehrein the identifying (135) the differing contrast comprises identification of one or more lost atoms in the sample (20).

6. The method of any of the above claims, wherein the sample (20) is graphene.

7. The method of any of the above claims, wherein the imaging is performed during or using irradiation with the energetic particles.

8. An apparatus for the determination of an isotope concentration comprising:

   - a microscope (10) for imaging a section of a sample (20) using energetic particles;
   - a detector for recording a series of images of the section of the sample (20);
   - a memory store (60) for storing a model; and
   - a processor (50) adapted to identify appearance of a differing contrast in at least one of the series of images, calculate (140) an accumulated irradiation dose leading to the appearance of the differing contrast and comparing (150) the accumulated irradiation dose with the stored model to determine (160) the isotope concentration in the sample (20).

9. The apparatus of claim 8, wherein the differing contrast is a result of at least one lost atom in the sample (20).

10. The apparatus of claim 8 or 9, wherein the energetic particles are electrons or ions.

11. The apparatus of claim 8 to 10, wherein the sample (20) is a low-dimensional sample.

12. The apparatus of claim 8 to 11, wherein the microscope is one of an transmission electron microscope, an ion microscope, or a neutral particle microscope.

## Fig. 1A

**130 Imaging**

40 Detector

To processor (50)

Lighter isotope $(m_1)$  ○

$e^-$  $e^-$

Heavier isotope $(m_2 > m_1)$  ●

| ○ | Atom |
|---|------|
| × | Vacancy |

20 Thin sample

30 Electron beam

$e^-$

$e^-$

$e^-$

$e^-$

125 Scan over sample

34 Electro-magnetic lens

32 Electron gun

10 Electron microscope

## Fig. 1B

132-160 Storage and analysis

From detector (40)

132 Store data

50 Processor

60 Datastore

Less scattering signal at vacancy

More scattering signal at atom

135 Identify vacancy

140 Calculate dose

150 Compare to model ⟶ 160 Determine isotope concentration

$e^-$ $(m_e)$ ⋯⟶ $m_1$ ⟶ $p_1 > p_2$

Probability of ejection

$m_2$ ⟶ $p_2$

Fig. 2

Fig. 3

Fig. 4

Fig. 5

Fig. 6

Europäisches
Patentamt

European
Patent Office

Office européen
des brevets

# EUROPEAN SEARCH REPORT

Application Number

EP 16 18 3371

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JANNIK C. MEYER ET AL: "Accurate Measurement of Electron Beam Induced Displacement Cross Sections for Single-Layer Graphene", PHYSICAL REVIEW LETTERS, vol. 108, no. 19, 1 May 2012 (2012-05-01), XP055342215, US ISSN: 0031-9007, DOI: 10.1103/PhysRevLett.108.196102 * the whole document * | 1-12 | INV. H01J37/28 G01N23/00 |
| A | US 2011/073562 A1 (ZETTL ALEXANDER K [US]) 31 March 2011 (2011-03-31) * paragraph [0073] * | 1-12 | |

TECHNICAL FIELDS
SEARCHED      (IPC)

H01J
G01N

The present search report has been drawn up for all claims

| Place of search | Date of completion of the search | Examiner |
|---|---|---|
| Munich | 6 February 2017 | Giovanardi, Chiara |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

 ...........................................................................

& : member of the same patent family, corresponding
document

EPO FORM 1503 03.82 (P04C01)

**EP 3 282 468 A1**

## ANNEX TO THE EUROPEAN SEARCH REPORT
## ON EUROPEAN PATENT APPLICATION NO.

EP 16 18 3371

This annex lists the patent family members relating to the patent documents cited in  the above-mentioned European search report.
The members are as contained in the European Patent Office EDP file on
The European Patent Office is in no way liable for these particulars which are merely given for the purpose of information.

06-02-2017

| Patent document cited in search report | Publication date | Patent family member(s) | Publication date |
|---|---|---|---|
| US 2011073562 A1 | 31-03-2011 | NONE | |

EPO FORM P0459

For more details about this annex : see Official Journal of the European Patent Office, No. 12/82

# EP 3 282 468 A1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **COOPER, V. R.** Van der Waals density functional: An appropriate exchange functional. *Physical Review B,* 2010, vol. 81, 161104
- **ENKOVAARA, J. et al.** Electronic structure calculations with GPAW: a real-space implementation of the projector augmented-wave method. *Journal of Physics: Condensed Matter,* 2010, vol. 22, 253202
- **LEWIS, J. B. ; ISHEIM, D. ; FLOSS, C. ; SEIDMAN, D. N.** 12C/13C-ratio determination in nanodiamonds by atom-probe tomography. *Ultramicroscopy,* 2015, vol. 159, 248-254
- **MCKINLEY, W. A., JR. ; FESHBACH, H.** The Coulomb scattering of relativistic electrons by nuclei. *Physical Review,* 1948, vol. 74, 1759-1763
- **MEYER, J. C. et al.** Accurate measurement of electron beam induced displacement cross sections for single-layer graphene. *Physical Review Letters,* 2012, vol. 108, 196102
- **STEPHAN, T.** TOF-SIMS in cosmochemistry. *Planetary and Space Science,* 2001, vol. 49, 859-906